# EUROPEAN PATENT SPECIFICATION

(11) **EP 2 292 810 B1**
(45) Date of publication and mention of the grant of the patent: **03.04.2013**
(21) Application number: 10173112.3
(22) Date of filing: 17.08.2010
(51) Int. Cl.: C23C 14/32, C23C 14/18, C23C 14/06, C23C 14/02, C23C 14/00

(54) **Coating of vitrified ceramic articles by pvd method**
Beschichtung von Artikeln aus Glaskeramik mittels PVD-Verfahren
Revêtement d'articles céramiques vitrifiés par procédé pvd

(30) Priority: 04.09.2009 TR 200906864
(43) Date of publication of application: 09.03.2011
(73) Proprietor: Eczacibasi Yapi Gerecleri Sanayi ve Ticaret A.S., 11300 Bilecik (TR)
(72) Inventor: Banat, Raid, Mafraq 25113 (JO); Tecen, Burhan, 26210, Eskisehir (TR); Bahar, Hakan, 11300, Bilecik (TR); Özen, Nimet, 26130, Eskisehir (TR)
(74) Representative: Cayli, Hülya

(56) References cited:
- DE-C1- 19 537 267
- GB-A- 2 202 237
- RU-C1- 2 039 844
- US-A1- 2008 173 536

## Description

### Technical Field

This invention relates to the coating of vitrified ceramic articles by PVD (Physical Vapor Deposition) method.

### Prior Art

Vitrified articles are widely used products in everyday life. Beautiful looking appearance, compliance with the hygienic standards and scratch- and impact-resistance of these articles are important features for the user. Most commonly used vitrified ceramic articles are produced by glaze coating on ceramic articles. As known, these glazing materials give a brilliant white color to the ceramic. However, the changing needs of the customers necessitate vitrified articles having different colors. Ceramic coating in different colors brings need for resistance to scratches and impacts.

For instance, thermally treated metal salt spray forms a matt metallic color on the ceramic surface. However, the surface obtained through this coating method is mechanically and chemically poor, i.e. non durable against impacts, scratches and cleaning agents.

Although the sputtering process consumes less energy when compared to the ion plasma deposition, it is not cost effective with respect to mass production of vitrified articles. The surface that can be coated is limited to 64500 mm² (100 in²) due to its low power. This method is not regarded suitable particularly for vitrified ceramic articles.

Compared to the PVD method, CVD (Chemical Vapor Deposition) coating technique is disadvantageous as it requires very high temperature for application.

The published patent application No US4839245 of the prior art discloses Zirconium Nitride coating on fans, compressors or turbine blades by PVD technique in order to increase abrasion resistance. The operating temperature is at such high temperatures as 415-670 °C degrees. The coating thickness ranges between 10 and 15 microns RU 2039844 C1 describes an example in which a porcelain tea service is provided with a decorative coating of titanium oxide by means of a magnetron sputtering process. The invention, the details of which are given below, discloses metal based coating of the outer surfaces of vitrified ceramic articles, which are coated with glazing materials, by PVD method. Along with the surfaces resistant to chemicals, corrosion and scratches, fashionable brilliant colors for decorative purposes can be obtained by the cathodic arc PVD technique. Zirconium-, chrome-, copper-, titanium-based materials are used as coating materials. The coating process is completed in 90 minutes at such low temperatures as 140-220 °C degrees, and the coating thickness ranges between 0.1 and 0.5 microns.

In the prior art, hard materials resistant to oxidation and high operating temperature, which also feature low friction coefficients, anti sticking and high resistance to scratch and impacts, are used as coating materials. However, these coatings have not been applied on vitrified ceramic articles. In addition, metal coating of the vitrified ceramic articles by the PVD technique is not known in the prior art.

### Brief Description of the Invention

This invention relates to the metal based coating of the outer surfaces of vitrified ceramic articles, which are coated with glazing materials such as FELDSPAR Na₂O.6SiO₂.Al₂O₃; FELDSPAR K₂O.Al₂O₃.6SiO₂; Quartz SiO₂; Kaolin 2SiO₂.Al₂O₃.7H₂O; Calcite CaCO₃; ZnO; Dolomite Ca-MgCO_{3;} ZrSiO₄ and such groups, by PVD method. The vitrified ceramic articles can be coated with gold, silver, bronze and copper color in this coating method; zirconium-, chrome-, copper- and titanium- etc. based materials can be utilized as coating materials. Brilliant fashionable colors as well as chemical-, corrosion- and scratch-resistant surfaces are obtained cathodic arc PVD technique, which is adopted as the method. Thermal, chemical and mechanical competencies are ensured by employing this novel cathodic arc PVD technique. Compared to the coating process of the prior art, this method can provide anti sticking, hard and dense coatings thanks to high ionization level.

### Aim of the Invention

The aim of the present invention is to ensure that vitrified ceramic articles are coated with zirconium-, chrome-, copper-, titanium-based metal materials by using PVD method. Another aim of the invention is to ensure that the coatings applied on ceramics possess impact resistance, anti sticking properties, low friction coefficients as well as resistance to oxidation and high operating temperatures.

### Disclosure of the Invention

The vitrified ceramic articles (e.g. washbasins) are coated with zirconium-, chrome-, copper-, titanium-based materials by the method of this invention with PVD technique. The coating recipe employed in this technique is important for the mechanical and chemical constancy of the coating. For instance; cleaning stages, pre-heating, density of the arc current, gaseous flow rate and gas ratio are significant parameters of this recipe. The desired results for both color and the mechanical and chemical endurance of the coating can be attained by these parameters.

Apart from this, geometrical structures of the articles in the vacuum chamber of the coating system and their positions with respect to each other are critical. For complete coating of the surfaces of the articles to be coated, it is required that the articles do not shade each other. For instance, a two-fold rotation racking system on which the articles to be coated may be advantageous for a homogenous coating on the whole surface. Furthermore, cleaning the articles to be coated with volatile organic compounds using microfiber cloth, and preheating them before coating process are crucial, as well.

Following the placement of the ceramic articles to be coated on the anode in the vacuum chamber,
i. The air in the vacuum chamber is evacuated and the chamber is heated at the fist stage.
ii. The air of the vacuum chamber is still evacuated without heating at the second stage.
iii. At the third stage, the cathode surface is cleaned with the plasma generated in the vacuum chamber.
iv. The ceramic surface is subjected to first ion etching with the plasma at the fourth stage.
v. The ceramic surface is subjected to second ion etching with the plasma at the fifth stage.
vi. The ceramic surface is subjected to non-reactive coating with the plasma at the sixth stage.
vii. At the seventh and the last stage, the ceramic surface is subjected to reactive coating with the plasma.

At the first stage mentioned above, the pressure of the vacuum chamber is pumped down to between 10⁻² and 10⁻⁴ mbar within 5-15 minutes. The vacuum chamber temperature is kept between 150 and 200 °C degrees.

The pressure of the vacuum chamber is pumped down to between 3x10⁻⁵ and 3x10⁻⁴ mbar within 10-20 minutes without heating at the second stage.

At the third stage, the contaminants on the cathode surface are cleaned by the plasma. During this process, a current of 50-150 A is conveyed to at least one cathode plate in the vacuum chamber for 2-4 minutes. The vacuum chamber is filled with 200 to 500 sccm (Standard Cubic Centimeters per Minute) of argon gas. In this embodiment where the bias voltage is 500-700 VDC, the vacuum chamber is kept between 130 and 200 °C degrees and this stage is applied for 2 - 4 minutes.

In the ion etching process at the fourth stage, a current of 100-225 A is conveyed to at least one cathode plate for 30-50 seconds, and the current can be cut and re-conveyed in the range of 10-30 seconds. The vacuum chamber is filled with 300-500 sccm of argon gas. In this embodiment where the bias voltage is 500-700 VDC, the vacuum chamber is kept between 160 and 220 °C degrees, and this stage is applied for 1.5 - 3.5 minutes.

In the ion etching process at the fifth stage, a current of 150-250 A is conveyed to at least one cathode plate for 10-30 seconds, and the current can be cut and re-conveyed in the range of 10-30 seconds. The vacuum chamber is filled with 300-700 sccm of argon gas. In this embodiment where the bias voltage is 700-1000 VDC, the vacuum chamber is kept between 160 and 220 °C degrees, and this stage is applied for 1.5 - 3.5 minutes.

In the non-reactive coating process at the sixth stage, a current of 150-250 A is conveyed to at least one cathode plate for 5-15 minutes. The vacuum chamber is filled with 500-1000 sccm of argon gas. In this embodiment where the bias voltage is 70-150 VDC, the vacuum chamber is kept between 100-150 °C degrees and between 10⁻² and 10⁻³ mbar pressure. (At this stage, a current of 3000-5000 Amps/h is supplied to the system).

In the reactive coating process at the seventh stage, a current of 150-250 A is conveyed to at least one cathode plate for 14-50 minutes. The vacuum chamber is filled with 200-500 sccm of argon gas and 5-125 sccm acetylene gas. In this embodiment where the bias voltage is 50-150 VDC, the vacuum chamber is kept between 100-150 °C degrees and between 4x10⁻³ and 4x10⁻⁴ mbar pressure. (At this stage a current of 3000-5000 Amps/h is supplied to the system).

Performed with the method above, the metal coating process on the vitrified ceramic articles enables obtaining durable and decorative coating surfaces thanks to the gases and flow rates used as well as the current values, ion etching and coating temperatures applied. Zirconium-, chrome-, copper-, titanium- etc. based materials are utilized as cathode plates.

## Claims

1. A method for coating vitrified ceramic articles with metal based materials by physical vapor deposition (PVD) technique wherein after the ceramic articles to be coated are placed on the anode while metal based materials are placed on the cathode in the vacuum chamber, the method respectively comprises the steps of
evacuating the air in the vacuum chamber at the first and the second stages;
cleaning the cathode surface by the plasma deposited in the vacuum chamber at the third stage; subjecting the ceramic surface to ion etching process at the fourth and fifth stages; non-reactive coating of the ceramic surface by means of the plasma at the sixth stage; reactive coating of the ceramic surface by means of the plasma at the seventh stage
and the method is **characterized in that**
a current of 100-225 A and 500-700 VDC bias voltage is conveyed to at least one cathode plate at the fourth stage;
a current of 150-250 A and 700-1000 VDC bias voltage is conveyed to at least one cathode plate at the fifth stage;
a current of 150-250 A is conveyed to at least one cathode plate, the vacuum chamber is filled with 500-1000 sccm of argon gas, 70-150 VDC bias voltage is supplied at the sixth stage;
a current of 150-250 A is conveyed to at least one cathode plate, the vacuum chamber is filled with 200-500 sccm of argon gas and 5-125 sccm acetylene gas, bias voltage is set to 50-150 VDC, the vacuum chamber is kept at 100-150 C degrees and between 4x10⁻³ and 4x10⁻⁴ mbar pressure at the seventh stage.

2. A method according to Claim 1 **characterized in that** the pressure of the vacuum chamber is pumped down to between 10⁻² and 10⁻⁴ mbar within 5-15 minutes and the vacuum chamber temperature is kept between 150-200 °C degrees at the first stage.

3. A method according to Claim 1 **characterized in that** the pressure of the vacuum chamber is pumped down to between 3x10⁻⁵ and 3x10⁻⁴ mbar within 10-20 minutes at the second stage.

4. A method according to Claim 1 **characterized in that** at the third stage, a current of 50-150 A is conveyed to at least one cathode plate in the vacuum chamber for 2-4 minutes; the vacuum chamber is filled with 200 to 500 sccm of argon gas; the bias voltage is 500-700 VDC; the vacuum chamber temperature is kept between 130 and 200 °C degrees; and this stage is applied for 2 - 4 minutes.

5. A method according to Claim 1 **characterized in that** at the forth stage, the current is conveyed to at least one cathode plate for 30-50 seconds, the current is cut and re-conveyed in the range of 10-30 seconds; the vacuum chamber is filled with 300-500 sccm of argon gas; the vacuum chamber temperature is kept between 160 and 220 °C degrees, and this stage is applied for 1.5 - 3.5 minutes.

6. A method according to Claim 1 **characterized in that** at the fifth stage, the current is conveyed to at least one cathode plate for 10-30 seconds, and the current can be cut and re-conveyed in the range of 10-30 seconds; the vacuum chamber is filled with 300-700 sccm of argon gas; the vacuum chamber temperature is kept between 160 and 220 °C degrees; and this stage is applied for 1.5 - 3.5 minutes.

7. A method according to Claim 1 **characterized in that** at the sixth stage, the current is conveyed to at least one cathode plate for 5-15 minutes while the vacuum chamber is kept between 100-150 °C degrees and between 10⁻² and 10⁻³ mbar pressure.

8. A method according to Claim 1 **characterized in that** the cathode plate is zirconium-based.

9. A method according to Claim 1 **characterized in that** the cathode plate is chrome-based.

10. A method according to Claim 1 **characterized in that** the cathode plate is copper-based.

11. A method according to Claim 1 **characterized in that** the cathode plate is titanium-based.

## Patentansprüche

1. Verfahren zum Beschichten vitrifizierter (verglaster) Keramikartikel mit metallbasierten Materialien durch eine PVD-Technik, wobei die zu beschichtenden Keramikartikel auf der Anode platziert werden, hingegen die metallbasierten Materialien auf der Kathode in der Vakuumkammer platziert werden, das Verfahren jeweils oder im Ablauf mit den folgenden Schritten
Evakuieren der Luft in/aus der Vakuumkammer im ersten und zweiten Schritt; Reinigen der Kathodenoberfläche durch oder über das abgeschiedene Plasma in der Vakuumkammer in der oder bei der dritten Stufe; Aussetzen oder Unterwerfen der Keramikoberfläche mit einem Ionen-Ätzprozess in der oder bei der vierten und fünften Stufe; nicht-reaktives Beschichten der Keramikoberfläche über oder mit dem Plasma in/bei der sechsten Stufe; reaktives Beschichten der Keramikoberfläche über oder mit dem Plasma in/bei der siebten Stufe
und das Verfahren **dadurch gekennzeichnet, dass**
ein Strom von 100 A bis 225 A und 500 V bis 700 V (Gleichspannung, DC) Vorspannung an oder zu zumindest einer Kathodenplatte in/bei der vierten Stufe angelegt oder zugeführt wird;
ein Strom von 150 A bis 250 A und (bei) 700 V bis 1000 V (DC, Gleichspannung) Vorspannung an zumindest eine Kathodenplatte in/bei der fünften Stufe angelegt oder zugeführt wird;
ein Strom von 150 A bis 250 A an zumindest eine Kathodenplatte gelegt wird oder übertragen wird, wobei die Vakuumkammer mit einem Argongas bei 500 sccm bis 1000 sccm gefüllt ist, wobei 70 V bis 150 V Biasspannung (Vorspannung) in/bei der sechsten Stufe zugeführt oder angelegt werden;
ein Strom von 150 A bis 250 A an zumindest eine Kathodenplatte geliefert oder geleitet wird, wobei die Vakuumkammer mit einem Argongas bei 200 sccm bis 500 sccm und mit 5 sccm bis 125 sccm Acetylengas gefüllt ist, die Vorspannung auf 50 V bis 150 V (Gleichspannung) gelegt wird, die Vakuumkammer bei 100 °C bis 150 °C gehalten wird und zwischen 4x10⁻³ mbar und 4x10⁻⁴ mbar Druck in/bei der siebten Stufe gehalten wird.

2. Verfahren nach Anspruch 1, **dadurch gekennzeichnet, dass** der Druck der Vakuumkammer auf einen Wert abgepumpt wird, der zwischen 10⁻² mbar und 10⁻⁴ mbar liegt, innerhalb von 5 min bis 15 min und die Temperatur der Vakuumkammer zwischen 150 °C bis 200 °C in/bei der ersten Stufe gehalten wird.

3. Verfahren nach Anspruch 1, **dadurch gekennzeichnet, dass** der Druck der Vakuumkammer abgepumpt wird auf einen Wert zwischen 3x10⁻⁵ mbar und 3x10⁻⁴ mbar, dies innerhalb von 10 min bis 20 min in/bei der zweiten Stufe.

4. Verfahren nach Anspruch 1, **dadurch gekennzeichnet, dass** in/bei der dritten Stufe ein Strom von 50 A bis 150 A übertragen oder zugeführt wird, dies an zumindest eine Kathodenplatte in der Vakuumkammer für 2 min bis 4 min; wobei die Vakuumkammer mit einem Argongas mit 200 sccm bis 500 sccm gefüllt ist; die Biasspannung zwischen 500 V und 700 V liegt; die Temperatur der Vakuumkammer zwischen 130 °C und 200 °C gehalten wird; und diese Stufe für 2 min bis 4 min angelegt wird oder erhalten wird/bleibt.

5. Verfahren nach Anspruch 1, **dadurch gekennzeichnet, dass** bei/in der vierten Stufe der Strom an zumindest eine Kathodenplatte für 30 sec bis 50 sec geliefert wird, der Strom unterbrochen oder abgeschaltet wird und wieder zugeführt wird in einem Bereich von 10 sec bis 30 sec; die Vakuumkammer mit einem Argongas bei 300 sccm bis 500 sccm gefüllt ist; die Temperatur der Vakuumkammer zwischen 160 °C und 220 °C gehalten wird, und diese Stufe angelegt oder erhalten wird/bleibt für 1,5 min bis 3,5 min.

6. Verfahren nach Anspruch 1, **dadurch gekennzeichnet, dass** bei/in der fünften Stufe der Strom an zumindest eine Kathodenplatte für 10 sec bis 30 sec geliefert wird, der Strom unterbrochen oder abgeschaltet und wieder zugeführt werden kann in einem Bereich von 10 sec bis 30 sec; die Vakuumkammer mit einem Argongas bei 300 sccm bis 700 sccm gefüllt ist; die Temperatur der Vakuumkammer zwischen 160 °C und 220 °C gehalten wird, und diese Stufe angelegt oder erhalten wird/bleibt für 1,5 min bis 3,5 min.

7. Verfahren nach Anspruch 1, **dadurch gekennzeichnet, dass** in/bei der sechsten Stufe der Strom an zumindest eine Kathodenplatte für 5 min bis 15 min zugeführt oder angelegt wird, während die Vakuumkammer auf einer Temperatur zwischen 100 °C bis 150 °C gehalten ist und einen Druck zwischen 10⁻² mbar und 10⁻³ mbar aufweist.

8. Verfahren nach Anspruch 1, **dadurch gekennzeichnet, dass** die Kathodenplatte zirconium-basiert ist.

9. Verfahren nach Anspruch 1, **dadurch gekennzeichnet, dass** die Kathodenplatte chrombasiert ist.

10. Verfahren nach Anspruch 1, **dadurch gekennzeichnet, dass** die Kathodenplatte kupferbasiert ist.

11. Verfahren nach Anspruch 1, **dadurch gekennzeichnet, dass** die Kathodenplatte titanbasiert ist.

## Revendications

1. Procédé de revêtement d'articles céramiques vitrifiés à l'aide de matériaux à base de métal par la technique de dépôt physique en phase vapeur (PVD), dans lequel après que les articles céramiques à revêtir sont placés sur l'anode alors que les matériaux à base de métal sont placés sur la cathode dans la chambre à vide, le procédé comprend respectivement les étapes
d'évacuation de l'air dans la chambre à vide au niveau des premier et deuxième étages ; de nettoyage de la surface de la cathode par le plasma déposé dans la chambre à vide au niveau du troisième étage ; de soumission de la surface de la céramique à un procédé de gravure à ions au niveau des quatrième et cinquième étages ; de revêtement non réactif de la surface de la céramique au moyen du plasma au niveau du sixième étage ; de revêtement réactif de la surface de la céramique au moyen du plasma au niveau du septième étage
et le procédé est **caractérisé en ce que**
un courant de 100 à 225 A et une tension de polarisation de 500 à 700 VCC sont acheminés vers au moins une plaque de cathode au niveau du quatrième étage ;
un courant de 150 à 250 A et une tension de polarisation de 700 à 1 000 VCC sont acheminés vers au moins une plaque de cathode au niveau du cinquième étage ;
un courant de 150 à 250 A est acheminé vers au moins une plaque de cathode, la chambre à vide est remplie de 500 à 1 000 cm³ normalisé par minute de gaz argon, une tension de polarisation de 70 à 150 VCC est fournie au niveau du sixième étage ;
un courant de 150 à 250 A est acheminé vers au moins une plaque de cathode, la chambre à vide est remplie de 200 à 500 cm³ normalisé par minute de gaz argon et de 5 à 125 cm³ normalisé par minute de gaz acétylène, la tension de polarisation est réglée à 50 à 150 VCC, la chambre à vide est maintenue à 100 à 150 °C et entre 4 x 10⁻³ et 4 x 10⁻⁴ mbar de pression au niveau du septième étage.

2. Procédé selon la revendication 1, **caractérisé en ce que** la pression de la chambre à vide est évacuée à entre 10⁻² et 10⁻⁴ mbar en l'espace de 5 à 15 minutes et la température de la chambre à vide est maintenue entre 150 et 200 °C au niveau du premier étage.

3. Procédé selon la revendication 1, **caractérisé en ce que** la pression de la chambre à vide est évacuée à entre 3 x 10⁻⁵ et 3 x 10⁻⁴ mbar en l'espace de 10 à 20 minutes au niveau du deuxième étage.

4. Procédé selon la revendication 1, **caractérisé en ce que**, au niveau du troisième étage, un courant de 50 à 150 A est acheminé vers au moins une plaque de cathode dans la chambre à vide pendant 2 à 4 minutes ; la chambre à vide est remplie de 200 à 500 cm³ normalisé par minute de gaz argon ; la tension de polarisation est de 500 à 700 VCC ; la température de la chambre à vide est maintenue entre 130 et 200 °C ; et cet étage est appliqué pendant 2 à 4 minutes.

5. Procédé selon la revendication 1, **caractérisé en ce que**, au niveau du quatrième étage, le courant est acheminé vers au moins une plaque de cathode pendant 30 à 50 secondes, le courant est coupé et réacheminé dans la plage de 10 à 30 secondes ; la chambre à vide est remplie de 300 à 500 cm³ normalisé par minute de gaz argon ; la température de la chambre à vide est maintenue entre 160 et 220 °C, et cet étage est appliqué pendant 1,5 à 3,5 minutes.

6. Procédé selon la revendication 1, **caractérisé en ce que**, au niveau du cinquième étage, le courant est acheminé vers au moins une plaque de cathode pendant 10 à 30 secondes, et le courant peut être coupé et réacheminé dans la plage de 10 à 30 secondes ; la chambre à vide est remplie de 300 à 700 cm³ normalisé par minute de gaz argon ; la température de la chambre à vide est maintenue entre 160 et 220 °C ; et cet étage est appliqué pendant 1,5 à 3,5 minutes.

7. Procédé selon la revendication 1, **caractérisé en ce que**, au niveau du sixième étage, le courant est acheminé vers au moins une plaque de cathode pendant 5 à 15 minutes alors que la chambre à vide est maintenue entre 100 et 150 °C et entre 10⁻² et 10⁻³ mbar de pression.

8. Procédé selon la revendication 1, **caractérisé en ce que** la plaque de cathode est à base de zirconium.

9. Procédé selon la revendication 1, **caractérisé en ce que** la plaque de cathode est à base de chrome.

10. Procédé selon la revendication 1, **caractérisé en ce que** la plaque de cathode est à base de cuivre.

11. Procédé selon la revendication 1, **caractérisé en ce que** la plaque de cathode est à base de titane.
